(19) Europäisches Patentamt
European Patent Office
Office européen des brevets

(11) **EP 2 733 849 B1**

(12) **EUROPÄISCHE PATENTSCHRIFT**

(45) Veröffentlichungstag und Bekanntmachung des Hinweises auf die Patenterteilung:
**11.03.2020 Patentblatt 2020/11**

(51) Int Cl.:
*H03K 17/16* (2006.01)          *H02M 1/32* (2007.01)
*H02M 1/08* (2006.01)          *H02M 1/00* (2006.01)

(21) Anmeldenummer: **12193416.0**

(22) Anmeldetag: **20.11.2012**

(54) **Verfahren und Vorrichtung zum variablen Einstellen eines IGBT-Schaltverhaltens**

Method and device for variable setting an IGBT switching characteristic

Procédé et dispositif de réglage variable d'une caractéristique de commutation IGBT

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**21.05.2014 Patentblatt 2014/21**

(73) Patentinhaber: **Valeo Siemens eAutomotive Germany GmbH**
**91056 Erlangen (DE)**

(72) Erfinder:
• **Beyer, Sandro**
  **91341 Röttenbach (DE)**
• **Fuchs, Enrico**
  **08141 Reinsdorf (DE)**
• **Leipenat, Michael**
  **91224 Pommelsbrunn (DE)**
• **Piepenbreier, Stefan**
  **90489 Nürnberg (DE)**
• **Völkel, Stefan, Dr.**
  **91058 Erlangen (DE)**

(74) Vertreter: **Dr. Gassner & Partner mbB**
**Wetterkreuz 3**
**91058 Erlangen (DE)**

(56) Entgegenhaltungen:
**DE-A1- 10 121 881    DE-A1-102011 083 841**

EP 2 733 849 B1

**Beschreibung**

Die vorliegende Erfindung betrifft eine Schaltungsvorrichtung mit einer Energiequelle, einem Zwischenkreis, einem IGBT, der über den Zwischenkreis an die Energiequelle gekoppelt ist, und einer Steuereinrichtung zum Abschalten des IGBT mit einer Abschaltgeschwindigkeit. Darüber hinaus betrifft die vorliegende Erfindung ein Verfahren zum Betreiben eines IGBT, der über einen Zwischenkreis an eine Energiequelle gekoppelt ist durch Abschalten des IGBT mit einer Abschaltgeschwindigkeit.

Bei zahlreichen elektrischen Antrieben sowie bei der Energiegewinnung werden heute meist Umrichter eingesetzt. Beispielsweise wird bei einem elektrisch betriebenen Fahrzeug eine Energiequelle (z.B. Hochvoltbatterie, Brennstoffzelle etc.) über einen Zwischenkreis und einen Umrichter an einen Antriebsmotor angeschlossen. Der Umrichter ist in der Regel mit sogenannten IGBTs (meist zwei pro Phase) realisiert. Jedem IGBT ist gängigerweise eine Freilaufdiode parallel geschaltet, die dem Motorstrom nach dem Kommutieren einen Freilaufpfad bietet.

In elektrisch betriebenen Fahrzeugen werden beispielsweise 600 V-IGBTs bei einer maximal auftretenden Zwischenkreisspannung von 450 V eingesetzt. Beim Abschalten dieser IGBTs entstehen hohe Abschaltüberspannungen. Darüber hinaus ist sicherzustellen, dass der Ausschaltwiderstand jedes IGBT für ein sicheres Abschalten des Maximalstroms bei der Zwischenkreisspannung von 450 V ausgelegt ist. Folglich muss bislang ein IGBT einen hohen Abschaltwiderstand besitzen, der aber zu einem langsamen Abschaltverhalten führt. Dies wiederum bedingt hohe Abschaltverluste und folglich einen schlechten Wirkungsgrad. Bislang wurden diese Abschaltverluste toleriert.

In der DE 10 2011 083 841 A1 ist ein Verfahren und eine Vorrichtung zum Steuern eines abschaltbaren Leistungshalbleiterschalters beschrieben. Dabei wird in Abhängigkeit einer gemessenen Kollektor-Emitter-Spannung eines abschaltbaren Leistungshalbleiterschalters und seines Soll-Steuersignals dieser abschaltbare Leistungshalbleiterschalter mittels einer aus verschiedenen Schaltgeschwindigkeiten ausgewählten Schaltgeschwindigkeit angesteuert. Somit kann die Schaltgeschwindigkeit eines abschaltbaren Leistungshalbleiterschalters an unterschiedliche Betriebsmodi angepasst werden, wodurch sich Schaltverluste verringern.

Die Aufgabe der vorliegenden Erfindung besteht somit darin, die Abschaltverluste bei IGBTs insbesondere für Umrichter zu reduzieren.

Erfindungsgemäß wird diese Aufgabe gelöst durch eine Schaltungsvorrichtung nach Anspruch 1.

Darüber hinaus wird erfindungsgemäß bereitgestellt ein Verfahren zum Betreiben eines IGBT nach Anspruch 11.

In vorteilhafter Weise wird also die Spannung in einem Zwischenkreis zwischen Energiequelle und IGBT erfasst und in Abhängigkeit von dieser erfassten Spannung die Abschaltgeschwindigkeit des IGBT gesteuert. Insbesondere ist es so möglich, bei niedrigen Zwischenkreisspannungen eine hohe Abschaltgeschwindigkeit zu realisieren, während sie bei hohen Zwischenkreisspannungen verhältnismäßig langsam sein kann. Damit lassen sich die Verluste insbesondere bei niedrigen Zwischenkreisspannungen reduzieren.

In einer Ausführungsform kann mindestens ein weiterer IGBT über den Zwischenkreis an die Energiequelle gekoppelt sein, und auch die Abschaltgeschwindigkeit des mindestens einen weiteren IGBT von der Steuereinrichtung in Abhängigkeit von der Spannung gesteuert werden. Dies hat den Vorteil, dass nicht nur die Zwischenkreisspannung zentral für mehrere IGBTs zentral erfasst, sondern auch deren Abschaltgeschwindigkeit zentral ermittelt werden kann.

Vorzugsweise besitzt die Schaltungsvorrichtung eine Stromquelle, über die das Abschalten des IGBT mittels der Steuereinrichtung steuerbar ist. Dies hat den Vorteil, dass das Gate des IGBT mit einem genau vorgebbaren Strom zum Abschalten entladen werden kann.

Hierzu kann die Stromquelle an das Gate des IGBT zu dessen Entladung angeschlossen sein und einen ersten Widerstand besitzen, zu dem wahlweise mindestens ein zweiter Widerstand parallel oder in Serie zuschaltbar ist. Durch gesteuertes Zuschalten eines zweiten Widerstands parallel oder in Serie zu einem ersten Widerstand kann die Stromstärke der Stromquelle und damit die Abschaltgeschwindigkeit des IGBT einfach variiert werden.

Vorteilhafterweise ist die Stromquelle zum Führen eines ersten Stroms einer ersten Stromstärke für ein Abschalten des IGBT mit einer ersten Abschaltgeschwindigkeit und zum Führen eines zweiten Stroms einer gegenüber der ersten Stromstärke geringeren zweiten Stromstärke zum Abschalten des IGBT mit einer gegenüber der ersten Abschaltgeschwindigkeit langsameren zweiten Abschaltgeschwindigkeit umschaltbar. Dabei erfolgt das Umschalten in Abhängigkeit von der Spannung im Zwischenkreis. Auf diese Weise lassen sich mindestens zwei verschiedene Abschaltgeschwindigkeiten realisieren, insbesondere eine hohe Abschaltgeschwindigkeit für niedrige Zwischenkreisspannungen und eine geringere Abschaltgeschwindigkeit für hohe Zwischenkreisspannungen.

Die Stromquelle kann einen Transistor aufweisen, dessen Kollektor an das Gate des IGBT angeschlossen ist, und dessen Basis an ein Schaltelement zum Aktivieren und Deaktivieren der Stromquelle angeschlossen ist. Damit lässt sich die Stromquelle zum Variieren der Abschaltgeschwindigkeit des IGBT auf sehr einfache Weise steuern. Ferner kann die Steuereinrichtung dazu ausgelegt sein, die Abschaltgeschwindigkeit mittels einer oder mehreren Schaltschwellen in Abhängigkeit von der Spannung im Zwischenkreis zu steuern. Demnach können zwei oder mehr verschiedene Abschaltgeschwindigkeiten vorgegeben werden, die in Abhängigkeit von vorgegebenen Schaltschwellen eingestellt werden.

Darüber hinaus kann die Schaltungsvorrichtung ein durch Hardware und/oder Software realisiertes Vergleichselement zum Vergleichen der Spannung im Zwischenkreis mit der einen oder den mehreren Schaltschwellen aufweisen. Im Falle der Software-Realisierung kann die Abschaltgeschwindigkeitssteuerung sehr flexibel an den jeweiligen Anwendungsfall angepasst werden.

Gemäß einer weiteren Ausführungsform kann die Schaltungsvorrichtung zum Variieren der Abschaltgeschwindigkeit eine an das Gate des IGBT angeschlossene Widerstandseinrichtung mit in Abhängigkeit von der Spannung im Zwischenkreis veränderlichem Widerstand aufweisen. Es ist also nicht zwangsläufig eine Stromquelle erforderlich, sondern das Entladen des Gates des IGBT kann auch über eine einfache Widerstandseinrichtung mit einem oder mehreren Widerständen erfolgen.

Ferner kann zusätzlich zu der Spannung ein von der Erfassungseinrichtung in dem Zwischenkreis erfasster Strom ($I_C$) in dem IGBT zum Steuern der Abschaltgeschwindigkeit herangezogen werden. Hierdurch lässt sich das Steuern der Abschaltgeschwindigkeit weiter verfeinern. Erfindungsgemäß wird zusätzlich zu der Spannung eine von der Erfassungseinrichtung erfasste, den IGBT charakterisierende Temperatur zum Steuern der Abschaltgeschwindigkeit herangezogen.

Die oben beschriebenen Vorrichtungsmerkmale stellen zumeist funktionelle Merkmale dar, die sich auch als Verfahrensmerkmale mit dem erfindungsgemäßen Verfahren kombinieren lassen.

Die vorliegende Erfindung wird nun anhand der beigefügten Zeichnungen näher erläutert, in denen zeigen:

FIG 1    den Spannungsverlauf zwischen Gate und Emitter beim Abschalten eines IGBT;

FIG 2    die korrespondierende Spannung zwischen Kollektor und Emitter am IGBT;

FIG 3    den korrespondierenden Kollektorstrom durch den IGBT;

FIG 4    die korrespondierende Verlustleitung;

FIG 5    ein Schaltungsdiagramm einer beispielhaften Schaltungsvorrichtung und

FIG 6    eine alternative Schaltungsvorrichtung.

Die nachfolgend näher geschilderten Ausführungsbeispiele stellen bevorzugte Ausführungsformen der vorliegenden Erfindung dar.

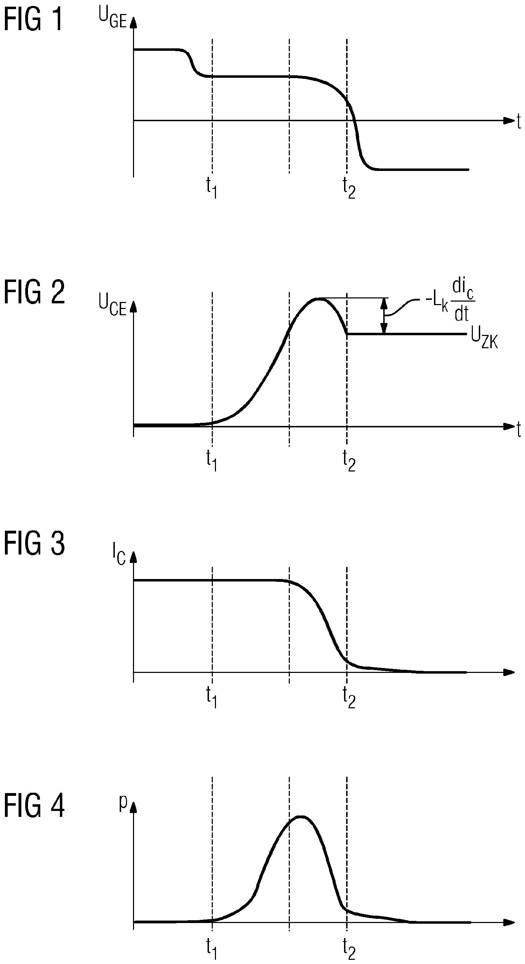

Anhand der FIG 1 bis 4 wird zunächst der Abschaltvorgang eines IGBT näher erläutert. In FIG 1 ist die Gate-Emitter-Spannung $u_{GE}$ dargestellt. Diese Steuerspannung des IGBT liegt zunächst auf einem positiven Niveau, bevor sie zu einem Zeitpunkt $t_1$ abgeschaltet wird. Sie bleibt dann während einer Entladephase bis zu einem Zeitpunkt $t_2$ noch auf einem reduzierten positiven Niveau, bevor sie nach dem Entladen des IGBT auf ein negatives Potenzial sinkt.

FIG 2 zeigt für den gleichen Zeitraum den Verlauf der Kollektor-Emitter-Spannung $u_{CE}$. Nach dem Abschalten der Gate-Emitter-Spannung $u_{GE}$ steigt die Kollektor-Emitter-Spannung $u_{CE}$ kontinuierlich auf einen Maximalwert an, der um eine Überspannung

$$L_k \ \left| \frac{di_c}{dt} \right|$$ über der Zwischenkreisspannung $U_{ZK}$

liegt. Dabei bedeutet $L_k$ die Kommutierungsinduktivität und $i_C$ der Kollektorstrom des IGBT. Anschließend fällt die Kollektor-Emitter-Spannung $u_{CE}$ auf das Niveau der Zwischenkreisspannung $U_{ZK}$. Insgesamt muss der IGBT also für die Maximalspannung (Zwischenkreisspannung plus Überspannung) ausgelegt sein, und seine Sperrspannung muss mindestens gleich groß sein oder noch um eine zusätzliche Reservespannung höher liegen.

FIG 3 gibt den Kollektorstrom $i_C$ des IGBT im selben Zeitraum wieder. Er sinkt, sobald die Kollektor-Emitter-Spannung $u_{CE}$ die Zwischenkreisspannung erreicht hat, bis zum Ende der Entladephase nahezu auf Null ab.

FIG 4 zeigt das Produkt aus Kollektor-Emitter-Spannung $u_{CE}$ und Kollektorstrom $i_{CE}$, nämlich die Verlustleistung p des IGBT. Die Entladephase endet im Wesentlichen zum Zeitpunkt $t_2$. Die Verlustleistung p nimmt in der Entladephase zwischen den Zeitpunkten $t_1$ und $t_2$ zunächst bis zu einem Maximalwert zu und sinkt dann kontinuierlich auf nahezu Null ab. Bei hoher Abschaltgeschwindigkeit ist die Entladephase kurz und bei langsamer Abschaltgeschwindigkeit entsprechend länger. Die maximale Verlustleistung bleibt jedoch annähernd gleich. Dies bedeutet, dass das Integral unter der Verlustleistungskurve bei hoher Geschwindigkeit kleiner ist als bei niedriger Geschwindigkeit. Damit ist die Verlustenergie im IGBT bei hoher Abschaltgeschwindigkeit geringer als bei niedriger Abschaltgeschwindigkeit.

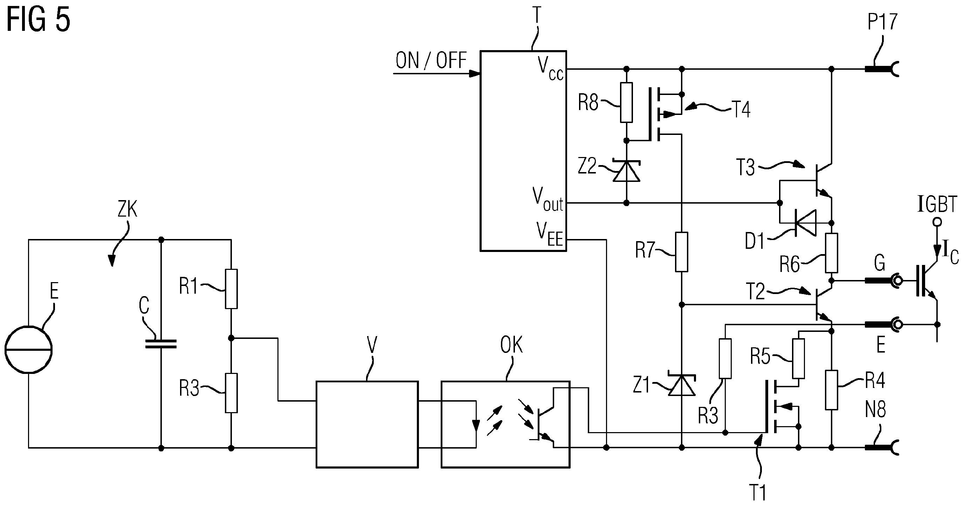

In FIG 5 ist ein Ausführungsbeispiel einer erfindungsgemäßen Schaltungsvorrichtung in Form eines Schaltplans wiedergegeben. Eine Energiequelle E ist über einen Zwischenkreis ZK an einen IGBT angeschlossen. Eine derartige Schaltung kann beispielsweise Teil des Antriebs eines elektrisch betriebenen Fahrzeugs (reines Elektrofahrzeug oder Hybridfahrzeug), eines Traktionsantriebs einer Lokomotive, eines Antriebs einer Fertigungsmaschine (z.B. Servoumrichter) oder dergleichen sein. Auch für die Energiegewinnung in Windkraftanlagen werden Umrichter eingesetzt, deren IGBTs entsprechend der Schaltung von FIG 5 gesteuert werden können. Prinzipiell können die IGBTs aller Arten von Umrichter auf diese Weise gesteuert werden.

Im Beispiel von FIG 5 ist im Zwischenkreis ZK ein Zwischenkreiskondensator C vorgesehen, zu dem ein Spannungsteiler R1, R2 parallel geschaltet ist. Die Spannung an dem Widerstand R2 des Spannungsteilers wird von einem Vergleicher V (hier auch als Erfassungseinrichtung bezeichnet) erfasst. Dieser vergleicht die für den Zwischenkreis ZK repräsentative Spannung mit einem oder mehreren intern abgelegten Schwellwerten. Das Vergleichsergebnis wird in Form eines digitalen, insbesondere binären Signals an eine Steuereinrichtung (in FIG 5 alle Bauteile zwischen Vergleicher V und IGBT oder ein Teil davon) und gemäß der Erfindung an einen Optokoppler OK weitergegeben. Ein ausgangsseitiger Fototransistor des Optokopplers ist mit seinem Emitter an eine negative Versorgungsspannung N8 (-8 V) angeschlossen. Sämtliche Spannungswerte sind im vorliegenden Dokument rein beispielhaft. Der Kollektor des Fototransistors ist über einen Widerstand R3 an den Emitter E des IGBT angeschlossen bzw. anschließbar. Ebenso liegt der Kollektor des Fototransistors an dem Gate eines MOSFET T1.

An das Gate G des IGBT ist eine Stromquelle angeschlossen, die einen Entladestrom des IGBT definiert aus dem Gate abführen soll und damit die Abschaltgeschwindigkeit beeinflusst. Die Stromquelle umfasst einen Bipolartransistor T2, dessen Kollektor an das Gate des IGBT und dessen Emitter über einen Widerstand R4 an die negative Versorgungsklemme N8 angeschlossen ist. Parallel zu dem Widerstand R4 ist ein weiterer Widerstand R5 über die Drain-Source-Strecke des MOSFET T1 an die negative Versorgungsklemme N8 angeschlossen. Außerdem verfügt die Stromquelle über eine Zenerdiode Z1, deren Kathode an die Basis des Transistors T2 und deren Anode an die negative Versorgungsklemme N8 angeschlossen ist.

Der IGBT bzw. die Stromquelle werden über einen Treiberbaustein T angesteuert. Dessen negative Versorgungsklemme $V_{EE}$ ist mit der negativen Versorgungsklemme N8 und dessen positive Spannungsversorgung $V_{CC}$ mit einer positiven Versorgungsklemme P17 (+17 V) verbunden. Der Treiberbaustein T erhält von außen einen Schaltbefehl für den IGBT (On / Off). In Abhängigkeit davon erzeugt der Treiberbaustein T an seinem Ausgang $V_{out}$ ein Ausgangssignal, das an die Basis eines Bipolartransistors T3 geführt ist. Der Kollektor des Transistors T3 ist mit der positiven Versorgungsklemme P17 und der Emitter des Transistors T3 über einen Widerstand R6 mit dem Gate des IGBT verbunden. Zwischen Emitter und Basis des Transistors T3 befindet sich eine Diode D1.

Zum Aktivieren und Deaktivieren der oben genannten Stromquelle ist die Basis des Transistors T2 über einen Widerstand R7 und die Drain-Source-Strecke eines MOSFET T4 an die positive Versorgungsklemme P17 gelegt. Das Gate des MOSFET T4 ist einerseits über einen Widerstand R8 mit der positiven Versorgungsklemme P17 und andererseits über eine Zenerdiode Z2 an die Ausgangsklemme des Treiberbausteins T angeschlossen.

Im Folgenden wird die Funktionsweise der Schaltungsvorrichtung von FIG 5 näher erläutert. Der Vergleicher V verwendet erfindungsgemäß einen oder mehrere Schwellwerte für seine Entscheidung. Im vorliegenden Beispiel besitzt er einen einzigen Schwellwert.

Erfasst er nun eine Spannung im Zwischenkreis ZK, die unterhalb des Schwellwerts liegt, so soll der IGBT rasch abgeschaltet werden, um geringe Abschaltverluste zu gewährleisten. Daher überträgt er kein Signal (Ausgangsspannung z. B. 0 V) an den Optokoppler so dass dessen Leuchtdiode nicht leuchtet. Daher sperrt sein Fototransistor und der MOSFET T1 leitet. Demzufolge sind die Widerstände R4 und R5 parallel geschaltet und es kann über den Transistor T2 ein hoher Strom aus dem Gate des IGBT fließen. Der IGBT wird also rasch entladen und damit rasch abgeschaltet.

Erfasst der Vergleicher V hingegen im Zwischenkreis ZK eine Spannung, die über dem Schwellwert liegt, leuchtet die Fotodiode und der Fototransistor leitet. Folglich sperrt der MOSFET T1 und der Strom aus dem Gate des IGBT kann nur über den Widerstand R4 abgeleitet werden. Dadurch schaltet der IGBT nur langsam ab.

Damit Strom über die Stromquelle abfließen kann, muss die Stromquelle aktiviert und deaktiviert werden. Dazu wird das Potenzial der Basis des Transistors T2 zunächst über die Zenerdiode Z1 auf ein konstantes Niveau gelegt. Soll nun der IGBT ausgeschaltet werden, so ist die Stromquelle und damit der Transistor T2 einzuschalten. Hierzu wird der MOSFET T4 mittels des Treiberbausteins T leitend geschaltet, sodass die Basis des Transistors T2 entsprechend positiv wird. Hierzu wird die negative Spannung -8 V vom Ausgang $V_{out}$ des Treiberbausteins T an die Basis des Transistors T3 gelegt, der dadurch sperrt und das Entladen des Gates über den Transistor T2 ermöglicht. Andernfalls, wenn an dem Ausgang $V_{out}$ des Treiberbausteins T +17 V angelegt wird, schaltet der Transistor T3 ein, wodurch das Potenzial am Gate des IGBT ebenfalls positiv wird, sodass dieser durchschaltet.

Für den Fall, dass der Vergleicher V über mehrere Schwellwerte verfügt, mit denen die Zwischenkreisspannung verglichen wird, kann der Vergleicher mehr als zwei verschiedene Ausgangssignale liefern. Entsprechend dieser Ausgangssignale können auch dann mehrere Widerstände parallel an den Widerstand R4 geschaltet werden, so dass mehr als zwei verschiedene Abschaltgeschwindigkeiten realisierbar sind.

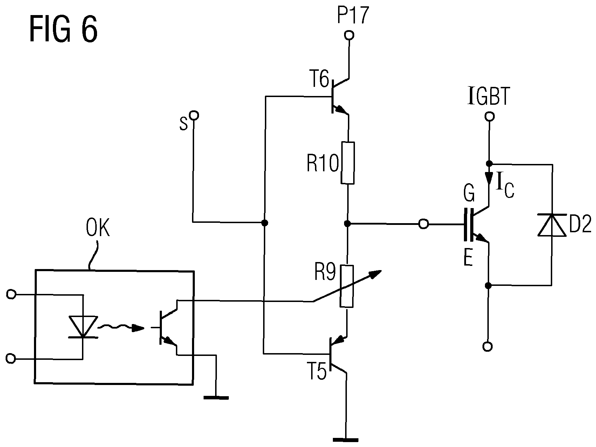

In FIG 6 ist ein Schaltplan eines wesentlichen Abschnitts gemäß einer weiteren Ausführungsform der erfindungsgemäßen Schaltungsvorrichtung dargestellt. In diesem Ausführungsbeispiel wird das Gate des IGBT nicht über eine Stromquelle, sondern lediglich über einen oder mehrere Widerstände bzw. eine Widerstandseinrichtung R9 entladen. Diese Widerstandseinrichtung R9 besitzt einen variablen Ohmschen Widerstand. Sie kann beispielsweise eine Serie von Widerstandselementen aufweisen, von denen einer oder mehrere je nach Bedarf kurzgeschlossen sind. Alternativ kann sie beispielsweise eine Parallelschaltung von mehreren Widerständen aufweisen, von denen einer oder mehrere gemäß dem Ausführungsbeispiel von FIG 5 je nach Bedarf hinzugeschaltet wird.

In dem Ausführungsbeispiel von FIG 6 wird der Widerstandswert der Widerstandseinrichtung R9 symbolhaft durch ein Ausgangssignal des Optokopplers OK gesteuert. Der Optokoppler kann wiederum wie in dem Beispiel von FIG 5 von einem Vergleicher angesteuert werden. Hinsichtlich etwaiger Steuerungsmöglichkeiten wird auf das Beispiel von FIG 5 verwiesen.

Zum Ansteuern des IGBT wird hier eine Bipolarendstufe mit zwei Transistoren T5 und T6 genutzt. Der Emitter des pnp-Transistors T5 ist an einem Pol der Widerstandseinrichtung R9 und der Kollektor beispielsweise an ein negatives Bezugspotenzial angeschlossen. Das Gate des IGBT wird also über die Widerstandseinrichtung R9 und den Transistor T5 entladen, wenn die Basis des Transistors T5 von der Steuerleitung s entsprechend negativ angesteuert wird. Gleichzeitig sperrt ein npn-Transistor T6, der ebenfalls an der Basis mit dem negativen Signal von der Steuerklemme s angesteuert wird, wobei dessen Kollektor mit der positiven Versorgungsklemme P17 (oder einer anderen positiven Versorgungsspannung) verbunden ist. Der Emitter des Transistors T6 ist über einen Widerstand R10 mit dem Gate des IGBT verbunden.

Liegt hingegen an der Steuerklemme s ein positives Potenzial an, sperrt der Transistor T5 und der Transistor T6 leitet. Demzufolge fließt Strom von der positiven Versorgungsklemme 17 über den Widerstand R10 in das Gate des IGBT. Folglich schaltet der IGBT durch. Der Vollständigkeit halber ist hier an dem IGBT parallel eine Freilaufdiode D2 geschaltet, was der üblichen Beschaltung in Umrichtern entspricht.

Beim Abschalten des IGBT, wenn der Strom also vom Gate über die veränderliche Widerstandseinrichtung R9 und den Transistor T5 abfließt, kann die Stromstärke dieses Entladestroms über die Widerstandseinrichtung R9 reguliert werden. Bei hohem Widerstand ist die Stromstärke gering und die Abschaltgeschwindigkeit entsprechend langsam. Umgekehrt ist bei niedrigem Ohmschen Widerstand die Stromstärke hoch, und entsprechend hoch ist auch die Abschaltgeschwindigkeit des IGBT.

In vorteilhafter Weise können also zum Steuern der Abschaltgeschwindigkeit des IGBT eine oder mehrere Schaltschwellen für die Zwischenkreisspannung festgelegt werden. Dadurch können die Abschaltgeschwindigkeiten und somit auch die Abschaltverluste in mehreren Schritten variiert werden.

Zur weiteren Verfeinerung der Steuerung der Abschaltgeschwindigkeit kann zusätzlich zu der Spannung der von der Erfassungseinrichtung in dem Zwischenkreis erfasste Strom $I_C$ in dem IGBT und/oder die von der Erfassungseinrichtung erfasste den IGBT charakterisierende Temperatur herangezogen werden. Der Kollektorstrom $I_C$ steht mit dem Ausgangsstrom des Umrichters in Zusammenhang. Die den IGBT charakterisierenden Temperatur kann direkt am IGBT oder auch indirekt in einem knappen Abstand neben dem IGBT in einem IGBT-Modul oder beispielsweise an der Bodenplatte des IGBT-Moduls, die an einen Kühlkörper angebunden werden kann, von der Erfassungseinrichtung gemessen werden.

Besitzt ein 3-phasiger-Umrichter beispielsweise 6 IGBTs, so kann deren Abschaltgeschwindigkeit gemeinsam, d.h. zentral gesteuert werden, indem die Steuersignale über einen gemeinsamen Vergleicher ermittelt werden, der die Zwischenkreisspannung zentral erfasst. Damit kann vermieden werden, dass für jeden IGBT die Zwischenkreisspannung und gegebenenfalls der Kollektorstrom bzw. die Temperatur des IGBT separat erfasst und eine entsprechende Abschaltgeschwindigkeitsanforderung separat ermittelt wird.

Ein wesentlicher Vorteil der oben beschriebenen Schaltungsanordnung besteht darin, dass die Abschaltgeschwindigkeitsanforderung, die hier von dem Vergleicher V stammt, potenzialfrei an den oder die Treiber des IGBT /der IGBTs durch den Optokoppler übermittelt wird.

**Patentansprüche**

1. Schaltungsvorrichtung mit

   - einer Energiequelle (E),
   - einem Zwischenkreis (ZK),
   - einem IGBT, der über den Zwischenkreis an die Energiequelle gekoppelt ist,
   - einer Steuereinrichtung zum Abschalten des IGBT mit einer Abschaltgeschwindigkeit, und
   - einer Erfassungseinrichtung zum Erfassen einer Spannung ($U_{ZK}$) in dem Zwischenkreis, wobei
   - die Erfassungseinrichtung zum Vergleichen einer für den Zwischenkreis (ZK) repräsentativen Spannung mit einer oder mehreren intern abgelegten Schwellwerten ausgebildet ist, wobei
   - die Steuereinrichtung zum Steuern der Abschaltgeschwindigkeit in Abhängigkeit von der Spannung ausgebildet ist,

   **dadurch gekennzeichnet, dass**
   das Vergleichsergebnis in Form eines digitalen Signals an einen Optokoppler (OK) der Steuereinrichtung weitergegeben wird, wobei zusätzlich zu der Spannung eine von der Erfassungseinrichtung erfasste den IGBT charakterisierende Temperatur zum Steuern der Abschaltgeschwindigkeit herangezogen wird.

2. Schaltungsvorrichtung nach Anspruch 1, wobei mindestens ein weiterer IGBT über den Zwischenkreis (ZK) an die Energiequelle (E) gekoppelt ist, und auch die Abschaltgeschwindigkeit des mindestens einen weiteren IGBT von der Steuereinrichtung in Abhängigkeit von der Spannung ($U_{ZK}$) gesteuert ist.

3. Schaltungsvorrichtung nach Anspruch 1 oder 2, die eine Stromquelle aufweist, über die das Abschalten des IGBT mittels der Steuereinrichtung steuerbar ist.

4. Schaltungsvorrichtung nach Anspruch 3, wobei die Stromquelle an das Gate des IGBT zu dessen Entladung angeschlossen ist und einen ersten Widerstand (R4) besitzt, zu dem wahlweise mindestens ein zweiter Widerstand (R5) parallel zuschaltbar oder in Serie kurzschließbar ist.

5. Schaltungsvorrichtung nach Anspruch 3 oder 4, wobei die Stromquelle zum Führen eines ersten Stroms einer ersten Stromstärke für ein Abschalten des IGBT mit einer ersten Abschaltgeschwindigkeit und zum Führen eines zweiten Stroms einer gegenüber der ersten Stromstärke geringeren zweiten Stromstärke zum Abschalten des IGBT mit einer gegenüber der ersten Abschaltgeschwindigkeit langsameren zweiten Abschaltgeschwindigkeit umschaltbar ist.

6. Schaltungsvorrichtung nach einem der Ansprüche 3 bis 5, wobei die Stromquelle einen Transistor (T2) aufweist, dessen Kollektor an das Gate des IGBT angeschlossen ist, und dessen Basis an ein Schaltelement (R7, T4) zum Aktivieren und Deaktivieren der Stromquelle angeschlossen ist.

7. Schaltungsvorrichtung nach einem der vorhergehenden Ansprüche, wobei die Steuereinrichtung dazu ausgelegt ist, die Abschaltgeschwindigkeit mittels einer oder mehrerer Schaltschwellen in Abhängigkeit von der Spannung ($U_{ZK}$) im Zwischenkreis (ZK) zu steuern.

8. Schaltungsvorrichtung nach Anspruch 7, wobei die Erfassungseinrichtung ein durch Hardware und/oder Software realisiertes Vergleichselement (V) zum Vergleichen der Spannung ($U_{ZK}$) im Zwischenkreis (ZK) mit der einen oder den mehreren Schaltschwellen aufweist.

9. Schaltungsvorrichtung nach Anspruch 1, 2, 7 oder 8, die zum Variieren der Schaltungsgeschwindigkeit eine an das Gate des IGBT angeschlossene Widerstandseinrichtung (R9) mit in Abhängigkeit von der Spannung ($U_{ZK}$) im Zwischenkreis (ZK) veränderlichem Widerstand aufweist.

10. Schaltungsvorrichtung nach einem der vorhergehenden Ansprüche, wobei zusätzlich zu der Spannung ein von der Erfassungseinrichtung in dem Zwischenkreis erfasster Strom ($I_C$) in dem IGBT zum Steuern der Abschaltgeschwindigkeit herangezogen wird.

11. Verfahren zum Betreiben eines IGBT, der über einen Zwischenkreis (ZK) an eine Energiequelle (E) gekoppelt ist, durch

- Abschalten des IGBT mit einer Abschaltgeschwindigkeit,
- Erfassen einer Spannung ($U_{ZK}$) in dem Zwischenkreis, wobei eine für den Zwischenkreis (ZK) repräsentativen Spannung mit einer oder mehreren intern abgelegten Schwellwerten verglichen wird,
- Steuern der Abschaltgeschwindigkeit in Abhängigkeit von der Spannung mittels einer Steuereinrichtung,

**gekennzeichnet durch**,

- Weitergeben des Vergleichsergebnisses in Form eines digitalen Signals an einen Optokoppler (OK) der Steuereinrichtung,
- zusätzliches Steuern der Abschaltgeschwindigkeit in Abhängigkeit von einer erfassten den IGBT charakterisierenden Temperatur.

**Claims**

1. A switching device comprising

- a power source (E),
- an intermediate circuit (ZK),
- an IGBT, which is coupled to the power source via the intermediate circuit,
- a control device for turning off the IGBT at a turn off speed, and
- a detection device for detecting a voltage ($U_{zk}$) in the intermediate circuit, wherein
- the detection device is configured to compare a voltage representative of the intermediate circuit (ZK) to one or more internally stored threshold values, wherein
- the control device is configured to control the turn off speed depending on the voltage,

**characterized in that**
the comparative result is passed to an optocoupler (OK) of the control device in the form of a digital signal, wherein
in addition to the voltage, a temperature characterizing the IGBT and detected by the detection device is used to control the turn off speed.

2. The switching device according to claim 1, wherein at least another IGBT is coupled to the power source (E) via the intermediate circuit (ZK), and the turn off speed of said at least other IGBT is also controlled by the control device depending on the voltage ($U_{zk}$).

3. The switching device according to claim 1 or 2, which comprises a current source allowing shut down of the IGBT to be controlled by means of the control device.

4. The switching device according to claim 3, wherein the current source is connected to the gate of the IGBT for discharge thereof and comprising a first resistor (R4), allowing at least one second resistor (R5) to optionally be connected in parallel or short-circuited in series.

5. The switching device according to claim 3 or 4, wherein the current source is switchable to carry a first current of a first current intensity for turning off the IGBT using a first turn off speed and to carry a second current of a second current intensity lower than the first current intensity for turning off the IGBT using a second turn off speed slower than the first turn off speed.

6. The switching device according to any one of claims 3 to 5, wherein the current source comprises a transistor (T2) the collector of which is connected to the gate of the IGBT and the base of which is connected to a switching element (R7, T4) for enabling and disabling the current source.

7. The switching device according to one of the preceding claims, the control device being adapted to control the turn off speed using one or more switching thresholds, depending on the voltage ($U_{zk}$) in the intermediate circuit (ZK).

8. The switching device according to claim 7, wherein the detection device comprises a comparative element (V), implemented by hardware and/or software, for comparing the voltage ($U_{zk}$) in the intermediate circuit (ZK) to the one or more switching thresholds.

9. The switching device according to claim 1, 2, 7 or 8, which, for varying the switching speed, comprises a resistivity device (R9) connected to the gate of the IGBT and having a resistivity which varies depending on the voltage ($U_{zk}$) in the intermediate circuit (ZK).

10. The switching device according to one of the preceding claims, wherein, in addition to the voltage, a current ($I_c$) in the IGBT detected by the detection means in the intermediate circuit is used to control the turn off speed.

11. A method for operating an IGBT coupled to a power source (E) via an intermediate circuit (ZK), the method comprising

- detecting a voltage ($U_{zk}$) in the intermediate circuit,
- a voltage representative of the intermediate circuit (ZK) being compared to one or more internally stored threshold values,
- controlling the turn off speed depending on the voltage using a control device,

**characterized by**,

- passing the comparative result to an optocoupler (OK) of the control unit in the form of a digital signal,
- additionally controlling the turn off speed depending on a temperature detected and characterizing the IGBT.

**Revendications**

1. Dispositif de circuit comportant

- une source d'énergie (E),
- un circuit intermédiaire (ZK),
- un IGBT qui est couplé à la source d'énergie via le circuit intermédiaire,
- un dispositif de commande pour déconnecter l'IGBT à une vitesse de coupure, et
- un dispositif de mesure pour mesurer une tension ($U_{ZK}$) dans le circuit intermédiaire, en ce que
- le dispositif de mesure est conçu pour comparer une tension représentative pour le circuit intermédiaire (ZK) avec une ou plusieurs valeurs seuil mémorisées au niveau interne, en ce que
- le dispositif de commande est conçu pour commander la vitesse de coupure en fonction de la tension,

**caractérisé en ce que**
le résultat de comparaison est transmis sous forme de signal numérique à un optocoupleur (OK) du dispositif de commande, **en ce que**
en complément de la tension une température caractéristique de l'IGBT mesurée par le dispositif de mesure est retenue pour la commande de la vitesse de coupure.

2. Dispositif de circuit selon la revendication 1, en ce qu'au moins un autre IGBT est couplé à la source d'énergie (E) via le circuit intermédiaire (ZK), et aussi la vitesse de coupure d'au moins un autre IGBT est commandée par le dispositif de commande en fonction de la tension ($U_{ZK}$).

3. Dispositif de circuit selon la revendication 1 ou 2, qui comporte une source de courant par le biais de laquelle la coupure de l'IGBT peut être commandée au moyen du dispositif de commande.

4. Dispositif de circuit selon la revendication 3, en ce que la source de courant est raccordée à la grille de l'IGBT pour sa décharge et a une première résistance (R4) à laquelle en option au moins une seconde résistance (R5) peut être raccordée en parallèle ou court-circuitée en série.

5. Dispositif de circuit selon la revendication 3 ou 4, en ce que la source de courant pour la conduction d'un premier courant d'une première intensité de courant pour une coupure de l'IGBT est commutable à une première vitesse de coupure et pour la conduction d'un second courant d'une seconde intensité de courant plus faible par rapport à la première intensité de courant pour la coupure de l'IGBT à une seconde vitesse de coupure plus lente par rapport à la première vitesse de coupure.

6. Dispositif de circuit selon l'une des revendications 3 à 5, en ce que la source de courant comporte un transistor (T2) dont le collecteur est raccordé à la grille de l'IGBT, et dont la base est raccordée à un élément de commutation (R7, T4) pour l'activation et la désactivation de la source de courant.

7. Dispositif de circuit selon l'une des revendications précédentes, en ce que le dispositif de commande est dimensionné de façon à commander la vitesse de coupure au moyen d'un ou de plusieurs seuils de commutation en fonction de la tension ($U_{ZK}$) dans le circuit intermédiaire (ZK).

8. Dispositif de circuit selon la revendication 7, en ce que le dispositif de mesure comporte un élément de comparaison (V) réalisé par le matériel et/ou le logiciel pour la comparaison de la tension ($U_{ZK}$) dans le circuit intermédiaire (ZK) avec un ou plusieurs seuils de commutation.

9. Dispositif de circuit selon la revendication 1, 2, 7 ou 8, qui comporte pour la variation de la vitesse de coupure un dispositif de résistance (R9) raccordé à la grille de l'IGBT avec une résistance variable en fonction de la tension ($U_{ZK}$) dans le circuit intermédiaire (ZK).

10. Dispositif de circuit selon l'une des revendications précédentes, en ce qu'en complément de la tension un courant ($I_c$) mesuré dans le circuit intermédiaire par le dispositif de mesure dans l'IGBT est retenu pour la commande de la vitesse de coupure.

11. Procédé de fonctionnement d'un IGBT qui est couplé via un circuit intermédiaire (ZK) à une source d'énergie (E), par

- déconnexion de l'IGBT à une vitesse de coupure
- mesure d'une tension ($U_{ZK}$) dans le circuit intermédiaire, en ce qu'une tension représentative pour le circuit intermédiaire (ZK) est comparée avec une ou plusieurs valeurs seuils mémorisées au niveau interne,
- commande de la vitesse de coupure en fonction de la tension au moyen d'un dispositif de commande,

**caractérisé par**

- transmission du résultat de comparaison sous forme d'un signal numérique à un optocoupleur (OK) du dispositif de commande,
- commande additionnelle de la vitesse de coupure en fonction d'une température mesurée caractéristique de l'IGBT.

FIG 1

$U_{GE}$

$t_1$       $t_2$       t

FIG 2

$U_{CE}$

$-L_k \dfrac{di_c}{dt}$

$U_{ZK}$

$t_1$       $t_2$       t

FIG 3

$I_C$

$t_1$       $t_2$

FIG 4

p

$t_1$       $t_2$

FIG 5

EP 2 733 849 B1

# FIG 6

**IN DER BESCHREIBUNG AUFGEFÜHRTE DOKUMENTE**

**In der Beschreibung aufgeführte Patentdokumente**

- DE 102011083841 A1